(19) Europäisches Patentamt
European Patent Office
Office européen des brevets

(11) **EP 4 073 920 B1**

(12) **EUROPÄISCHE PATENTSCHRIFT**

(45) Veröffentlichungstag und Bekanntmachung des Hinweises auf die Patenterteilung:
**12.07.2023  Patentblatt 2023/28**

(21) Anmeldenummer: **20820155.8**

(22) Anmeldetag: **09.12.2020**

(51) Internationale Patentklassifikation (IPC):
**H02M 7/5387** (2007.01)     **G01R 27/26** (2006.01)
**H02M 1/00** (2006.01)

(52) Gemeinsame Patentklassifikation (CPC):
**H02M 7/53871; G01R 27/2611; H02M 1/0025;**
**Y02E 10/56**

(86) Internationale Anmeldenummer:
**PCT/EP2020/085268**

(87) Internationale Veröffentlichungsnummer:
**WO 2021/116166 (17.06.2021 Gazette 2021/24)**

(54) **VERFAHREN ZUR IDENTIFIKATION EINER FILTERINDUKTIVITÄT EINES NETZWECHSELRICHTERS**

METHOD FOR IDENTIFICATION OF LINE FILTER INDUCTANCE OF AN INVERTER

PROCÉDÉ D'IDENTIFICATION D'UNE INDUCTANCE D'UN FILTRE DE RÉSEAU D'UN ONDULEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.12.2019  EP 19214654**

(43) Veröffentlichungstag der Anmeldung:
**19.10.2022  Patentblatt 2022/42**

(73) Patentinhaber: FRONIUS INTERNATIONAL GmbH
4643 Pettenbach (AT)

(72) Erfinder:
• PIELER, Roland
4600 Wels-Thalheim (AT)
• ROTHBÖCK, Michael
4600 Wels-Thalheim (AT)
• WIESER, Stefan
4600 Wels-Thalheim (AT)
• KREUZER, Harald
4600 Wels-Thalheim (AT)

(74) Vertreter: **Patentanwälte Pinter & Weiss OG**
**Prinz-Eugen-Straße 70**
**1040 Wien (AT)**

(56) Entgegenhaltungen:
**EP-A1- 3 236 568**

• **WU FENGJIANG ET AL: "Improved Elimination Scheme of Current Zero-Crossing Distortion in Unipolar Hysteresis Current Controlled Grid-Connected Inverter", IEEE TRANSACTIONS ON INDUSTRIAL INFORMATICS, IEEE SERVICE CENTER, NEW YORK, NY, US, Bd. 11, Nr. 5, 1. Oktober 2015 (2015-10-01), Seiten 1111-1118, XP011670969, ISSN: 1551-3203, DOI: 10.1109/TII.2015.2470540 [gefunden am 2015-10-02]**

**Beschreibung**

Die gegenständliche Offenbarung betrifft ein Verfahren zum Betreiben eines Wechselrichters und einen Wechselrichter.

Zur Filterung des von der Schaltungseinheit eines Wechselrichters erzeugten Wechselstroms werden in den einzelnen Phasenleitern der Wechselstromseite Filterspulen verbaut. Für ein gutes Regelverhalten ist es vorteilhaft, wenn die Filterspulen ein ausreichend lineares Verhalten aufweisen, was relativ teure Filterspulen ausreichender Größe voraussetzt. Filterspulen werden zunehmend im Bereich nicht-linearer Induktivität betrieben um eine kleinere Bauform zu ermöglichen, oder weil die Kernmaterialien eine nicht-lineare Charakteristik der Induktivität bewirken. Nicht-Linearitäten werden auch gezielt eingesetzt, um unterschiedliche Anforderungen durch verschiedene Betriebsbereiche besser zu erfüllen. Weicht die angenommene Charakteristik bzw. das Induktivitätsprofil der Spule von der tatsächlichen Charakteristik ab, kann sich das problematisch auf die Sinuswellenform des Stromes auswirken.

Aus US 2015/0016162 A1 ist es bekannt, bei der Regelung einer Pulsweitenmodulation für einen Photovoltaik-Wechselrichter, in Abhängigkeit einer aktuellen Stromstärke einen einer Filterinduktivität zugeordneten Wert zu ermitteln und in der Regelung zu berücksichtigen. Der zugeordnete Wert der Filterinduktivität wird dabei aus einer Zuordnungstabelle oder einer Näherungsformel ermittelt. In beiden Fällen wird das Induktivitätsprofil als bekannt vorausgesetzt.

Der Fachartikel "Improved Elimination Scheme of Current Zero-Crossing Distortion in Unipolar Hysteresis Current Controlled Grid-Connected Inverter", Wu Fengjiang et al, 2015, lehrt ein Verfahren zum Betreiben eines Wechselrichters, wobei charakteristische Werte einer Filterinduktivität in Abhängigkeit einer Mehrzahl von Messpunkten eines Spulenstroms und einer Spulenspannung identifiziert werden. Die Anwendung dieses Verfahrens ist allerdings auf einen Einsatz während des Betriebs des Wechselrichters beschränkt.

Die EP 3 236 568 A1 offenbart ein Verfahren zum Betrieb eines Wechselrichtersystems, wobei eine Spannung an einem Netzanschlusspunkt gemessen wird und aufgrund einer automatisierten Bewertung dieser Messwerte eine automatische Anpassung einer Schaltfrequenz erfolgt. Zu diesem Zweck wird eine Berechnungsmöglichkeit für eine wirksame Gesamtinduktivität angegeben, wobei diese Gesamtinduktivität insbesondere den Einfluss des angeschlossenen Netzes beschreibt und folglich nur unzureichend auf die Eigenschaften des Wechselrichtersystems selbst eingeht.

Unter Laborbedingungen kann ein Induktivitätsprofil einer Filterspule oder einer Induktivität mit heutigem Stand der Technik relativ einfach ermittelt werden und für eine Steuerung oder Regelung hinterlegt werden. Die Laborbedingungen unterscheiden sich jedoch in der Regel von den Einbau- und Betriebsbedingungen einer Induktivität. Meistens bezieht sich das hinterlegte Induktivitätsprofil auf den Durchschnitt einer Stichprobe von mehreren Induktivitäten und nicht auf die tatsächlich verbaute Induktivität. Sobald eine Induktivität in einem Gerät verbaut ist, wird es sehr schwierig, ein brauchbares Induktivitätsprofil zu ermitteln, besonders dann, wenn sich das Gerät in Betrieb befindet. Erschwerend kann ein Strom, der durch die Induktivität im Gerät fließt, Verzerrungen hoher Frequenz beinhalten.

In der Praxis besteht daher oft das Problem, dass das hinterlegte Induktivitätsprofil für eine Induktivität bzw. Filterspule vom tatsächlichen Induktivitätsprofil (d.h. dem tatsächlichen Verlauf des Induktivitätswerts der Induktivität in Bezug auf die Stromstärke) aus den eben genannten Gründen erheblich abweicht. Davon abgesehen sind Induktivitätsprofile von Induktivitäten durch Alterung, veränderliche Umgebungsbedingungen und Fertigungstoleranzen nicht einheitlich oder über die Zeit konstant. Besonders wenn Induktivitäten im nicht-linearen Bereich betrieben werden, können Abweichungen vom hinterlegten Induktivitätsprofil ein problematisches Ausmaß erreichen. Schlussendlich kann auch die zuvor stattgefundene Abfolge von Änderungen des Stroms durch die Induktivität einen Einfluss auf den tatsächlich gerade vorliegenden Wert der Induktivität bei einem bestimmten Strom haben. Das heißt, dass es bei einem Stromwert nicht nur einen, sondern mehrere mögliche Werte für die Induktivität geben kann. Die Ursache dafür liegt im Vorliegen einer Hysterese bei der Magnetisierung von Kernmaterialien von Induktivitäten bzw. Filterinduktivitäten.

Die gegenständliche Offenbarung betrifft Verfahren und Vorrichtungen, mit denen diese und weitere Probleme des Standes der Technik behoben werden können.

In einem ersten Aspekt betrifft die gegenständliche Offenbarung ein Verfahren nach Anspruch 1 zum

Betreiben eines Wechselrichters, welches die folgenden Schritte aufweist:

- mittels einer Schaltungseinheit des Wechselrichters Anlegen einer Wechselspannung an eine Phasenleitung, in der eine Filterinduktivität angeordnet ist,
- Ermitteln von für einen Spulenstrom und eine Spulenspannung der Filterinduktivität charakteristischen Werten im Bereich einer Mehrzahl von Messpunkten, wobei zumindest jeweils zwei Messpunkte an zumindest einer Flanke eines Stromrippels liegen,
- Ermitteln, aus den charakteristischen Werten, eines ersten Werts der Induktivität der Filterinduktivität für einen ersten Wert des Spulenstroms,
- Gegebenenfalls ermitteln zumindest eines weiteren Wertes der Induktivität der Filterinduktivität für zumindest einen weiteren Wert des Spulenstroms,
- Ermitteln zumindest eines auf den Spulenstrom bezogenen Induktivitätsprofils der Filterinduktivität unter Verwendung des ermittelten ersten Wertes der der Induktivität der Filterinduktivität und unter Verwendung des zumindest einen ermittelten weiteren Wertes der Induktivität der Filterinduktivität, wobei das Induktivitätsprofil eine Abhängigkeit der Werte der Induktivität der Filterinduktivität vom Spulenstrom beschreibt,

- Regeln der Schaltungseinheit des Wechselrichters mittels einer Regeleinheit zur Erzeugung eines Wechselstroms in der Phasenleitung, wobei zumindest ein Parameter der Regelung gemäß einem ermittelten stromabhängigen

Induktivitätsprofil laufend an den aktuellen Wert der Induktivität angepasst wird, wobei das Induktivitätsprofil vor der ersten Inbetriebnahme des Wechselrichters und gegebenenfalls zusätzlich in planmäßigen Intervallen vor einer oder vor jeder Inbetriebnahme des Wechselrichters ermittelt wird.

Die Regelung des Wechselrichters verfügt somit immer über ein aktuelles Induktivitätsprofil, dass dem tatsächlichen Induktivitätsprofil der Filterinduktivität sehr genau entspricht, wodurch die Regelqualität verbessert wird.

In einer vorteilhaften Ausführungsform des Verfahrens kann das Ermitteln des ersten Werts der Filterinduktivität die folgenden Schritte umfassen:

- Ermitteln einer ersten Flankensteigung $m_x$ eines Stromrippels für den ersten Wert des Spulenstroms,
- Ermitteln eines ersten Werts $U_x$ der Spulenspannung der ersten Flankensteigung,
- Ermitteln des ersten Werts $L(I_{L_y})$ der Filterinduktivität aus der ersten Flankensteigung und dem ersten Wert der Spulenspannung gemäß der Formel

$$L(I_{L_y}) = \frac{U_x}{m_x} \ .$$

Die Auswertung der Flankensteigung von Stromrippeln erlaubt eine sehr genaue Ermittlung eines Wertes der Filterinduktivität bei einer bestimmten Stromstärke. Die Flankensteigung des Stromrippels entspricht dabei der Ableitung des Stroms nach der Zeit di/dt, sodass sich der Wert der Filterinduktivität unmittelbar durch Verwendung der Formel für die Induktivität

$$u_L = L \cdot \frac{di}{dt}$$

beziehungsweise

$$L = u_L \cdot \frac{dt}{di}$$

ermitteln lässt.

Das Ermitteln einer Flankensteigung erfordert üblicherweise die Auswertung von zumindest zwei Messpunkten, die an derselben Flanke eines Stromrippels liegen. Jede Flanke eines Stromrippels liegt zwischen zwei Schaltpunkten der Schaltungseinheit, sodass die Zeitdauern der Flanken in der Regelung bekannt sind. Diese Kenntnis kann dazu genutzt werden sicherzustellen, dass für die Ermittlung der Flankensteigung nur Messwerte verwendet werden, die auf einer einzigen Flanke desselben Stromrippels liegen. Genauso ist bekannt, ob gerade eine steigende oder eine fallende Flanke eines Stromrippels vorliegt. Wenn die Ermittlung der Induktivität mit nur zwei Messpunkten auf einer Flanke durchgeführt werden soll, wird ein Messpunkt nach einem ersten Schaltpunkt und ein weiterer Messpunkt vor einem folgenden Schaltpunkt vorgesehen. Die zwei Messpunkte liegen dabei möglichst weit auseinander.

Zur Erhöhung der Genauigkeit bzw. zur Berücksichtigung einer Krümmung einer Flanke werden mehr als zwei Messpunkte auf einer Flanke vorgesehen. Gegebenenfalls können auch mehr als zwei Messpunkte zur Ermittlung der Flankensteigung herangezogen und ein Mittelwert für die Berechnung der Filterinduktivität herangezogen werden. Dabei werden Mittelwerte für den Spulenstrom und die Spulenspannung über eine Flanke eines Stromrippels gebildet, woraus der entsprechende Induktivitätswert für einen mittleren Spulenstrom $I_{Ly}$ ermittelt wird. Dadurch kann beispielsweise in erster Näherung der Einfluss der Krümmung der Flanken des Rippelstroms berücksichtigt werden. Bei stark nichtlinearen Induktivitäten oder entsprechend ausgedehnten Rippelflanken, wie sie z.B. beim Einsatz H-Brücken auftreten können, unterscheidet sich nämlich die Flankensteigung am Anfang der Flanke von der Flankensteigung am Ende der Flanke. Durch die Verwendung eines Mittelwertes kann eine verbesserte Regelqualität erzielt werden. Falls im Zuge der Regelung Flanken von Stromrippeln entstehen, die für eine Messung der Flankensteigung zu kurz sind (d.h. in denen insbesondere nur ein einziger Messpunkt liegt), werden diese Flanken bei der Auswertung nicht berücksichtigt.

Eine Charakteristik bzw. ein Induktivitätsprofil einer Filterspule lässt sich mit charakteristischen Werten erfassen. Charakteristische Werte ergeben sich grundsätzlich aus der Abhängigkeit von Spulenstrom und Spulenspannung und deren Änderungsraten. Als Beispiel in diesem Zusammenhang sei als charakteristischer Wert die Steigung einer Flanke eines Stromrippels genannt. Anstelle des Stromes kann auch der magnetische Fluss für die Formulierung von charakteristischen Werten herangezogen werden. Änderungen der Charakteristik bzw. des Induktivitätsprofils einer Filterspule, die z.B. in Abhängigkeit von ihrer Temperatur, der Amplitude des Wechselstroms, der Schaltfrequenz bzw. der verwendeten Schaltungseinheit/Topologie in Erscheinung treten, können ebenfalls mit geeigneter Erfassung dieser Abhängigkeiten und deren zeitlichen Zusammenhang als charakteristische Werte ermittelt bzw. abgebildet werden.

Die charakteristischen Werte umfassen in jedem Fall solche, aus denen sich zumindest ein Wert der Induktivität einer Spule ermitteln lässt. Mehrere von einem Spulenstrom und Spulenspannung abhängige Werte der Induktivität werden zur Ermittlung zumindest eines Induktivitätsprofiles herangezogen.

In vorteilhafter Weise kann die Ermittlung des Spulenstroms durch eine Messung mit einer Abtastfrequenz erfolgen, die zumindest dem zweifachen und vorzugsweise einem Vielfachen einer Taktfrequenz einer über die Schaltungseinheit umgesetzten Pulsweitenmodulation entspricht. Diese "Überabtastung" (bzw. "Oversampling") erlaubt eine sehr genaue Auswertung des Verlaufs der Stromrippel. Die Stromrippel entstehen z.B. durch Schaltvorgänge zur Pulsweitenmodulation. Das Verfahren kann mit unterschiedlichen Arten von Pulsweitenmodulationen ausgeführt werden, beispielsweise auf Basis einer fixen Frequenz oder einer variablen Frequenz.

In vorteilhafter Weise kann die Flankensteigung durch Bilden der Stromdifferenz zwischen zumindest zwei Abtastschritten und unter Berücksichtigung der Abtastfrequenz ermittelt werden. Der Wert für die Flankensteigung kann somit als Differenz des Messwerts von aufeinanderfolgenden zwei Strommessungen dividiert durch die Länge des Messintervalls auf einfache Weise in guter Näherung ermittelt werden.

In vorteilhafter Weise können nach der Ermittlung des Induktivitätsprofils dessen Steigung und/oder Krümmung ermittelt werden.

In vorteilhafter Weise kann bei der Regelung der Schaltungseinheit des Wechselrichters mittels einer Regeleinheit zur Erzeugung eines Wechselstroms in einer Phasenleitung zumindest ein Parameter der Regelung laufend an den aktuellen Wert der Steigung und/oder Krümmung des Induktivitätsprofils angepasst werden.

Wenn der Wechselrichter mehrere Phasenleitungen mit jeweils einer Filterinduktivität aufweist, kann in einer weiteren vorteilhaften Ausführungsform zumindest ein weiteres Induktivitätsprofil einer weiteren Filterinduktivität in einer weiteren Phasenleitung ermittelt und bei der Regelung berücksichtigt werden. Das hierin offenbarte Verfahren lässt sich somit sowohl auf einphasige, als auch auf mehrphasige Wechselrichter vorteilhaft anwenden. Der Begriff "eine Filterinduktivität" ist dabei auch so zu verstehen, dass "eine Filterinduktivität" aus mehreren miteinander verschalteten Filterinduktivitäten gebildet sein kann. Der Einfachheit halber werden die in Summe für die Regelung wirksamen Filterinduktivitäten einer Phase als "eine Filterinduktivität" betrachtet.

In vorteilhafter Weise kann die Ermittelung des Induktivitätsprofils zusätzlich regelmäßig oder ständig während des Betriebs des Wechselrichters durchgeführt werden. Die gewählte Strategie hängt auch von den vorhandenen Ressourcen ab. Beispielsweise bindet die Ermittlung von Spulenstrom und Spulenspannung mit einer ausreichend hohen Abtastfrequenz ("Oversampling") sowie die Ermittlung der Werte der Filterinduktivität und gegebenenfalls die Anpassung des Induktivitätsprofils Rechenkapazität in der Regeleinheit. Um diese freizugeben kann die Ermittlung daher beispielsweise über eine (oder mehrere) Periode(n) erfolgen, wobei das ermittelte Induktivitätsprofil gegebenenfalls schrittweise in einem Speicher abgelegt wird. Die Regelung kann dann in weiterer Folge auf die abgespeicherten Werte zugreifen, ohne zusätzliche Rechenkapazität zu benutzen. Die nächste Ermittlungsperiode kann dann entweder durch ein bestimmtes Ereignis ausgelöst werden (z.B. wenn die Regeleinheit eine verringerte Regelqualität feststellt), oder die Ermittlung kann in regelmäßigen Intervallen während des Betriebs erfolgen.

In einem weiteren Aspekt betrifft die gegenständliche Offenbarung einen Wechselrichter nach Anspruch 12, mit einer Schaltungseinheit, mit der eine Wechselspannung an zumindest eine Phasenleitung anlegbar ist, wobei in der Phasenleitung eine Filterinduktivität angeordnet ist und wobei die Schaltungseinheit mittels einer Regeleinheit geregelt wird, wobei ein Spulenstrom der Filterinduktivität und eine Spulenspannung der Filterinduktivität von der Regeleinheit ermittelbar ist, und wobei die Regeleinheit ausgebildet ist, die folgenden Schritte auszuführen:

- Ansteuern der Schaltungseinheit zum Anlegen einer Wechselspannung an eine Phasenleitung des Wechselrichters,
- Ermitteln eines ersten Werts der Filterinduktivität für einen ersten Wert des Spulenstroms,
- Gegebenenfalls ermitteln zumindest eines weiteren Wertes der Filterinduktivität für einen weiteren Wert des Spulenstroms,
- Ermitteln eines auf den Spulenstrom bezogenen Induktivitätsprofils der Filterinduktivität unter Verwendung des ermittelten ersten Wertes der Filterinduktivität und gegebenenfalls unter Verwendung des zumindest einen ermittelten weiteren Wertes der Filterinduktivität,
- Regeln der Schaltungseinheit des Wechselrichters zur Erzeugung eines Wechselstroms in der Phasenleitung, wobei zumindest ein Parameter der Regelung gemäß dem ermittelten stromabhängigen Induktivitätsprofil laufend an den aktuellen Spulenstrom angepasst wird, und
- wobei die Regeleinheit oder eine andere Recheneinheit des Wechselrichters ausgebildet ist, das Induktivitätsprofil der Filterinduktivität vor der ersten Inbetriebnahme des Wechselrichters und gegebenenfalls zusätzlich in planmäßigen Intervallen vor einer oder vor jeder Inbetriebnahme des Wechselrichters zu ermitteln.

Ein solcher Wechselrichter ermöglicht einerseits eine verbesserte Regelleistung und damit einhergehend eine idealere Sinusform der Wechselgrößen am Wechselrichterausgang. Andererseits können günstigere Bauteile verwendet werden, die oftmals eine nicht bewältigbare Herausforderung für übliche Regelungen darstellen. Insbesondere kleinere und leichtere Induktivitäten ermöglichen das Vorantreiben der Miniaturisierung und Kostenoptimierung. Die kleineren und leichteren Induktivitäten weisen aber durch die früher eintretende magnetische Sättigung eine nichtlineare Abhängigkeit der Induktivität vom Strom auf, welche durch die erfindungsgemäßen Lösungen berücksichtigt wird.

In vorteilhafter Weise kann die Regeleinheit ausgebildet sein, das Induktivitätsprofil der Filterinduktivität zusätzlich regelmäßig oder ständig während des Betriebs des Wechselrichters durchzuführen. Dadurch lässt sich stets eine optimale Regelleistung gewährleisten.

In einer vorteilhaften Ausgestaltung kann der Wechselrichter mehrere Phasen mit jeweils einer Filterinduktivität aufweisen, wobei für jede Filterinduktivität ein Induktivitätsprofil ermittelbar ist. Dies erlaubt es, die gegenständlichen Lehren auch auf mehrphasige Wechselrichter vorteilhaft anzuwenden.

Die gegenständliche Erfindung wird nachfolgend unter Bezugnahme auf die Figuren 1 bis 3 näher erläutert, die beispielhaft, schematisch und nicht einschränkend vorteilhafte Ausgestaltungen der Erfindung zeigen. Dabei zeigt

Fig. 1 eine beispielhafte schematisierte Schaltungsanordnung eines Wechselrichters,

Fig. 2 eine diagrammhafte Darstellung von qualitativen Induktivitätsprofilen

Fig. 3a eine diagrammhafte Darstellung eines Stromverlaufs

Fig. 3b eine diagrammhafte Darstellung eines Stromverlaufs mit Spulenspannung

Fig. 3c eine diagrammhafte Darstellung eines Stromverlaufs mit zwei Messpunkten und

Fig. 4 eine diagrammhafte Darstellung der Anpassung eines Induktivitätsprofils

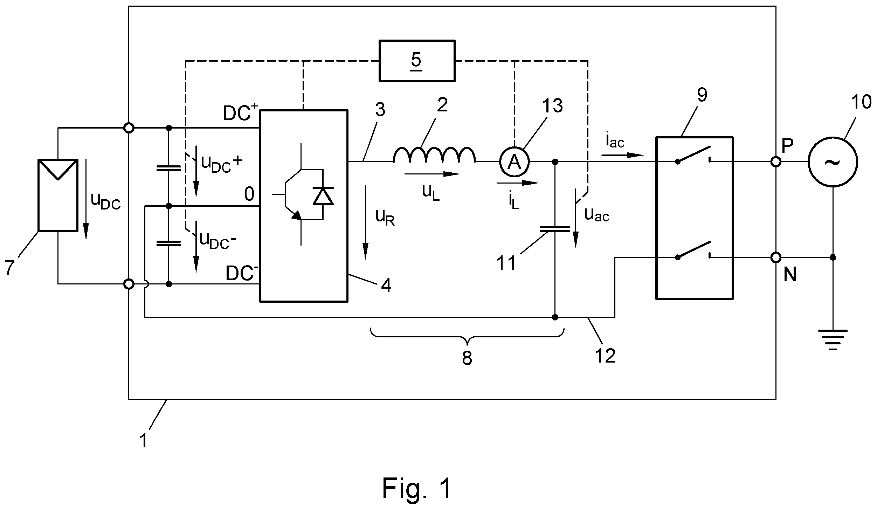

Die in Fig. 1 dargestellte Schaltanordnung eines Wechselrichters 1 wandelt ein Gleichstrompotential $U_{DC}$ von einer Gleichstromquelle 7 mithilfe einer an sich bekannten Schaltungseinheit 4 in eine getaktet geschaltete, rechteckig verlaufende Rechteck-Wechselspannung $u_R$ um, die an eine Phasenleitung 3 angelegt wird. Die rechteckig verlaufende Rechteck-Wechselspannung $u_R$ wird dann von einer Filtereinheit 8 in eine annähernd sinusförmig verlaufende Wechselspannung (Filterkondensatorspannung $u_{ac}$) beziehungsweise einen dementsprechend annähernd sinusförmig verlaufenden Wechselstrom $i_{ac}$ umgewandelt.

Der Wechselrichter 1 kann über ein Netzrelais 9 mit den Leitungen eines Stromnetzes 10 verbunden werden, wobei im dargestellten einfachen Fall der Wechselrichter an eine Phase P und einen Neutralleiter N des Stromnetzes 10 angeschlossen ist. Die Wechselspannung $u_{ac}$ speist bei geschlossenem Netzrelais 9 einen Phasenstrom $i_{ac}$ in das Stromnetz 10 ein.

Für die Ermittlung eines Induktivitätsprofils ist der Wechselrichter üblicherweise mit den Phasen eines Versorgungsnetzes verbunden. Das Induktivitätsprofil kann aber auch mit einem Wechselrichter ohne Verbindung zu Phasen eines Versorgungsnetzes durch geeignete Schaltvorgänge und einer Verbindung zum Neutralleiter des Versorgungsnetzes vor einem Einspeisebetrieb ermittelt werden. Im Rahmen der Herstellung eines Wechselrichters werden an diesem in der Regel Tests durchgeführt, im Rahmen welcher Ströme fließen, die mit den gewöhnlich im Betrieb auftretenden Strömen vergleichbar sind. So können ohne zusätzlichen Zeit- und Mittelaufwand bereits bei der Herstellung genaue Induktionsprofile vom Wechselrichter selbst ermittelt werden. Dadurch kann sichergestellt werden, dass schon bei der ersten Inbetriebnahme bzw. dem ersten Einspeisebetrieb ein einwandfreier Strom erzielt wird.

Die Filtereinheit 8 umfasst eine in der Phasenleitung 3 angeordnete Filterspule 2 und einen Filterkondensator 11. Die Filterspule 2 ist mit ihrem ersten Ende direkt mit der Schaltungseinheit 4 verbunden, vom zweiten Ende der Filterspule 2 führt die Phasenleitung 3 weiter zum Netzrelais 9. Der Filterkondensator 11 ist im Bereich zwischen dem zweiten Ende der Filterspule 2 und dem Netzrelais 9 zwischen der Phasenleitung 3 und dem Neutralleiter 12 angeordnet.

Die Schaltungseinheit 4 ist in Fig. 1 nur schematisch dargestellt, wobei zahlreiche Topologien von Schaltungseinheiten 4 bekannt sind, die für die Erzeugung der Wechselspannung verwendet werden können. Die in Fig. 1 dargestellte Schaltungseinheit 4 entspricht einer Dreipunkt-Schaltung, wobei die Phasenleitung 3 mit drei Gleichstrompotentialen beaufschlagt werden kann, einem positiven Gleichstrompotential DC+, einem negativen Gleichstrompotential DC- und einem neutralen Gleichstrompotential 0 von einem Zwischenkreismittelpunkt, der mit dem Neutralleiter 12 verbunden ist. Die Lehren der gegenständlichen Offenbarung können jedoch auch auf Topologien angewendet werden, die lediglich zwei Gleichstromeingänge (z.B. DC+ und DC-) oder auch nur einen Gleichstromeingang, dessen Potential vom Neutralleiter unterscheidet, aufweisen. Eine Topologie der Schaltungseinheit 4, die für den in Fig. 1 dargestellten Fall verwendet werden kann, ist beispielsweise die sogenannte NPC-Topologie, es können jedoch auch beliebige andere Topologien verwendet werden, wobei die Anpassung der Schaltung an eine andere Topologie zu den Fähigkeiten des Durchschnittsfachmanns zählt. Die Schaltung kann beispielsweise auch zwei oder drei Phasenausgänge mit jeweils einer Filterspule aufweisen, wie dies im Fachbereich bekannt ist. Die Topologie der Schaltanordnung 4 des Wechselrichters kann beispielsweise ausgewählt sein aus H-Brücke, H5, HERIC, REFU, FB-DCBP, FB-ZVR, NPC, Conergy-NPC und mit diesen verwandten Topologien. Die derart bezeichneten Topologien sind im Fachbereich bekannt und müssen daher hierin nicht näher erläutert werden.

Die Schalteinheit 4 ist mit einer Regeleinheit 5 verbunden, welche das Öffnen und Schließen der in der Schalteinheit 4 vorgesehenen Halbleiterschalter regelt. Üblicherweise wird dabei ein Pulsweitenmodulationsschema angewendet. Je nach Regelschema verfügt die Regeleinheit 5 über mehrere Messwerte, die als Eingangsgrößen der Regelung verwendet werden. In Fig. 1 sind als Eingangsgrößen der Regelung die Zwischenkreisspannungen $u_{dc}^+$ und $u_{dc}^-$ des positiven und des negativen Gleichstrompotentials gegenüber dem Zwischenkreismittelpunkt (d.h. die Spannungen über die Zwischenkreiskondensatoren), die Wechselspannung $u_{ac}$ über den Filterkondensator 11 und der Spulenstrom $i_L$ durch die Filterspule 2 durch Strichlinien beispielhaft und schematisch dargestellt. Die zur Ermittlung dieser Eingangsgrößen erforderlichen Messeinrichtungen und Schaltungen sind dem Fachmann bekannt und müssen hierin nicht detailliert beschrieben werden. Je nach Topologie können auch weitere oder andere Messwerte als Eingangsgrößen der Regelung vorgesehen sein. Gegebenenfalls können auch andere Größen gemessen werden, wenn sich aus diesen die für die Regelung erforderlichen Eingangsgrößen direkt oder indirekt ermitteln lassen.

So lassen sich in dem in Fig. 1 dargestellten Beispiel etwa die Spulenspannung $u_L$ als Subtraktion der von der Schaltungseinheit 4 erzeugten Rechteck-Wechselspannung $u_R$ und der Filterkondensatorspannung $u_{ac}$ ermitteln. Die Rechteck-Wechselspannung $u_R$ ist wiederum anhand der jeweiligen Schalterstellung der Schaltungseinheit 4 und der Werte der Zwischenkreisspannungen ermittelbar. Der Spulenstrom $i_L$ kann beispielsweise durch einen vor oder nach der Filterspule 2 in der Phasenleitung 3 angeordneten Strommesser 13 direkt ermittelt werden. Gegebenenfalls kann eine Strommessung auch an einer anderen Stelle erfolgen, beispielsweise kann der Phasenstrom $i_{ac}$ und der Strom über den Filterkondensator 11 gemessen werden, wobei sich der Spulenstrom $i_L$ aus diesen Werten ergibt. Der Spulenstrom kann jedoch auch indirekt ermittelt werden, beispielsweise durch Messen des magnetischen Flusses der Filterspule. Für die hierin offenbarten Verfahren ist es wesentlich, dass eine Möglichkeit besteht, auf eine beliebige Weise den Spulenstrom $i_L$ und die Spulenspannung $u_L$ zu ermitteln.

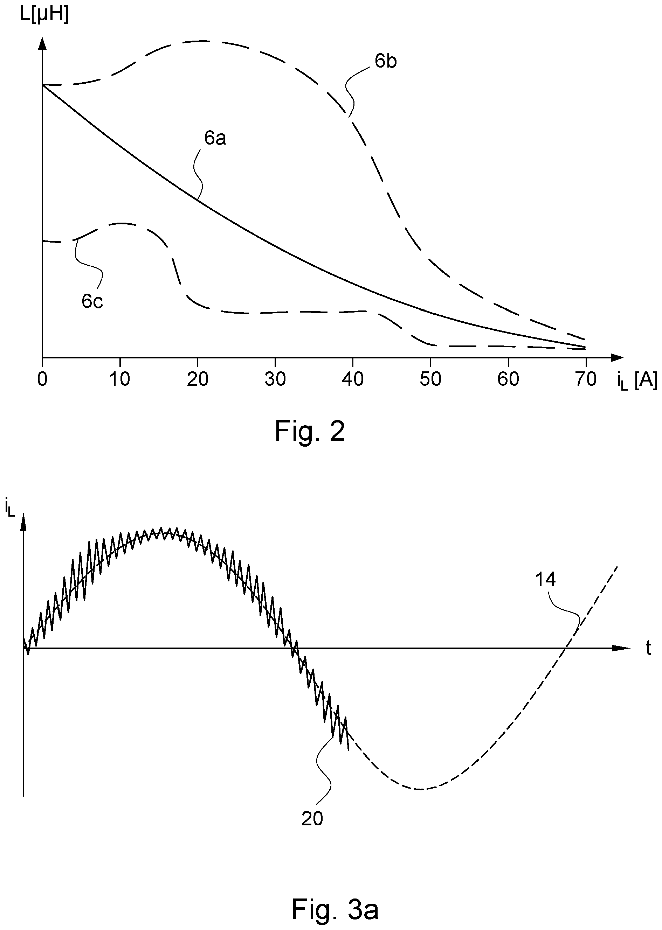

Die Filterspule 2 kann in Strombereichen betrieben werden, in dem ein nichtlineares Induktivitätsprofil vorliegt, wie es anhand der unterschiedlichen Verläufe des Induktivitätsprofils 6a, 6b und 6c in Fig. 2 beispielhaft und qualitativ dargestellt ist. Die Induktivität L der Filterspule 2 ist durch ein Induktivitätsprofil (6a, 6b, 6c) als ein vom Spulenstrom abhängiger Wert definiert.

Die Regeleinheit 5 des Wechselrichters verwendet als Parameter auch den Wert der Induktivität der Filterspule 2. Wenn jedoch ein falscher Wert verwendet wird, führt dies zu einer schlechten Regelqualität, was zu unerwünschten Spannungs- bzw. Stromschwankungen führen kann. Dies kann einerseits eine Blindleistung unerwünscht verändern oder die Sinusform des Stromes $i_{ac}$ verzerren, andererseits können Bauteile übermäßig beansprucht werden oder es kann sogar zu Fehlabschaltungen des Wechselrichters kommen.

Um (günstige und kleine) Filterspulen 2 mit einem stark ausgeprägten nichtlinearem Induktivitätsprofil 6 verwenden zu können, können die von der Induktivität abhängigen Parameter der Regelung in Abhängigkeit vom aktuellen Wert des Spulenstroms $i_L$ ständig angepasst werden. Die Messung bzw. Ermittlung des Spulenstroms erfolgt bei einem erfindungsgemäßen Wechselrichter sehr genau und mit einer hohen Abtastungsrate, sodass die Regelung über den gesamten Phasenverlauf sehr genau an den aktuellen Wert des Spulenstroms angepasst werden kann. Somit kann eine hohe Regelgüte erzielt werden, allerdings nur insofern das Induktivitätsprofil 6 korrekt ist.

Das Induktivitätsprofil 6 einer Filterspule 2 kann sich jedoch durch Umgebungseinflüsse (z.B: Temperatur, Magnetfelder benachbarter Drosseln oder dergleichen) und/oder Alterung erheblich verändern. Dazu kommen noch die herstellungsbedingten Toleranzen und Abweichungen der Induktivitäten von Filterspulen. Trotz der (vermeintlich) optimalen Anpassung der Reglung an ein nur vermeintlich richtiges Induktivitätsprofil 6 können daher in der Praxis Regelfehler auftreten.

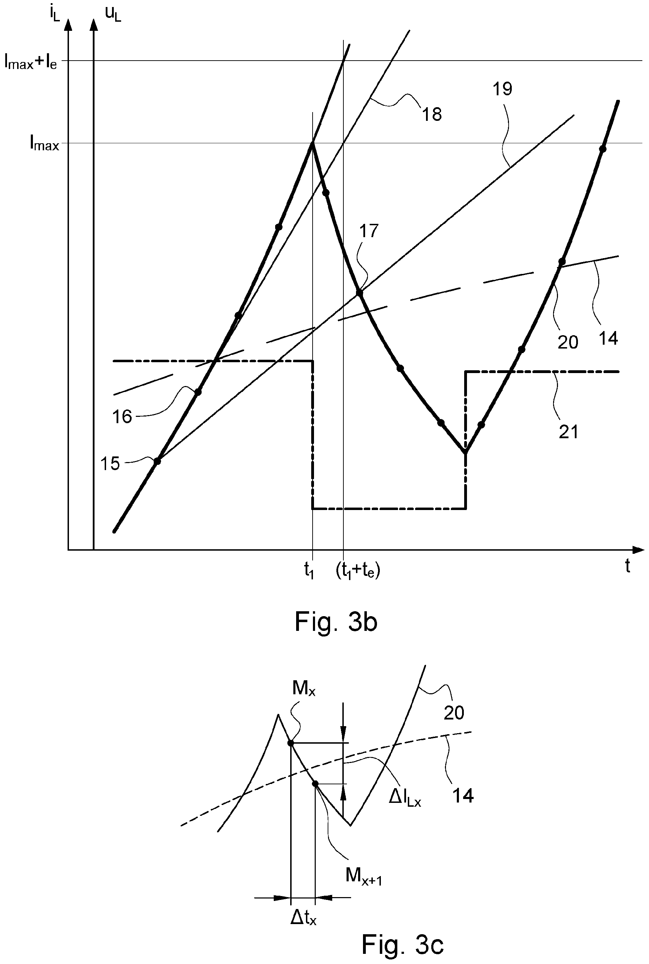

In Fig. 3a ist ein Verlauf eines Spulenstroms $i_L$ über die Zeit t in einem Diagramm dargestellt. Abgesehen von den dargestellten Stromrippeln in Fig. 3a gibt es Verfahren zur Erzeugung eines Wechselstroms, bei denen die Stromrippel um ein Vielfaches größer sein können. Beispielsweise ist aus dem Stand der Technik ein Verfahren bekannt, bei dem jeder Stromrippel einen Nulldurchgang aufweist und dadurch speziell im Bereich der Stromamplitude der Grundwelle ein Induktivitätsprofil einer Filterinduktivität mit einem oder wenigen dieser großen Rippel ermittelt werden kann. Der Strom in Fig. 3a folgt im Wesentlichen einem sinusförmigen Verlauf (der sogenannten Grundwelle 14 des Stroms), weist jedoch deutlich erkennbare Stromrippel auf, die in den in Fig. 3b und 3c dargestellten Diagrammausschnitten vergrößert dargestellt sind. Die in den Diagrammausschnitten der Fig. 3b und 3c dargestellten Verläufe können sich dabei auf einem unterschiedlichen Bereich der Grundwelle 14 befinden, die Darstellung ist jedoch beliebig gewählt und ist nicht einschränkend auszulegen.

Das Auftreten solcher Stromrippel ist technisch bedingt und in einem gewissen Ausmaß nicht vermeidbar. Vor allem im Bereich der Stromamplituden können zu große Stromrippel jedoch Überströme bewirken, die zu einer Fehlabschaltung (oder gar zu einer Beschädigung von Bauteilen) führen können. Daher ist es ein weiteres Ziel der Erfindung, mit Hilfe eines genauen Induktivitätsprofils die Größe der Stromrippel vor deren Auftreten zu kennen und gegebenenfalls durch Anpassung des Modulationsverfahrens bzw. der Regelung der Schaltungseinheit in ihrer Größe zu begrenzen, um eine Fehlabschaltung zu vermeiden. Wesentlich für die Regelgüte ist dabei eine genaue Kenntnis der Parameter der Filterschaltung. Bei nicht-linearen Filterspulen 2 sind Insbesondere möglichst getreue Kenntnisse des Induktivitätsprofils 6 erforderlich.

Jeder Stromrippel weist eine ansteigende und eine abfallende Flanke auf, wobei die Flanken jeweils die Grundwelle 14 des Stroms kreuzen. Die Messabtastung des Spulenstroms $i_L$ erfolgt mit einer hohen Frequenz, sodass für jede Flanke eines Stromrippels eine Vielzahl an Messungen, beispielsweise zehn oder mehr Messungen, jedoch mindestens zwei, zur Verfügung stehen. Die Messabtastungen sind in Fig. 3b beispielhaft durch Messpunkte 15, 16, 17 dargestellt. In Fig. 3b ist zu erkennen, dass jede Flanke eine Krümmung aufweist. Die Krümmung der Flanke ist durch das nicht-lineare Verhalten der Filterspule 2 bedingt. Es ist auch möglich, die Krümmung einer Flanke mittels drei oder mehr Messpunkten auf einer Flanke besser zu berücksichtigen, indem zumindest zwei Werte der Induktivität an verschiedenen Stellen der gekrümmten Flanke ermittelt werden.

Zwischen zwei Messabtastungen auf einer Flanke eines Stromrippels kann eine Flankensteigung m des Stromrippels ermittelt werden. Eine zu niedrige Abtastrate bzw. ungeeignete Lage oder Auswahl der Messpunkte für die Ermittlung von Induktivitätswerten führt dabei zu unerwünschten Ergebnissen, wie dies anhand der Geraden 18 und 19 in Fig. 3b verdeutlicht wird. Die Gerade 18 wird durch die Messpunkte 15 und 16 gebildet und weist eine Steigung $m_x$ auf. Durch die Krümmung der Flanken des Spulenstroms bzw. Rippelstroms 20 weicht die Gerade 18 zunehmend von der Flanke mit den Messpunkten 15 und 16 ab. Eine Regelung, die beim Spulenstrom $I_{max}$ die fallende Flanke zum Zeitpunkt $t_1$ einleiten sollte, würde dies anhand eines einfachen Induktivitätsprofils vereinfacht skizziert gemäß der Steigung m der Gerade 18, erst zum Zeitpunkt $(t_1+t_e)$ einleiten. Zum Zeitpunkt $(t_1+t_e)$ würde der Spulenstrom bereits $I_{max}+I_e$ betragen, da sich der Spulenstrom durch die um $t_e$ verspätete Einleitung um $I_e$ weiter erhöht hätte. Noch größere Abweichungen würden sich ergeben, wenn bei der Ermittlung der Steigung m zwei Messpunkte herangezogen werden, die nicht auf einer Flanke liegen, beispielsweise die in Fig. 3b dargestellten Messpunkte 15 und 17. Die Gerade 19 durch die Messpunkte 15 und 17 veranschaulicht, dass das Erreichen von $I_{max}$ zu einem viel späteren Zeitpunkt von einer Regelung erwartet werden und dadurch noch deutlicher überschritten werden würde, als im Beispiel anhand Gerade 18. Die Regelung wäre in diesem Fall wahrscheinlich nicht mehr möglich. Um Fehlabschaltungen zu vermeiden und die Regelqualität zu verbessern, werden zur erfindungsgemäßen Ermittlung eines Induktivitätsprofils der Bezug der Messpunkte zur jeweiligen Flanke und insbesondere eine vorhandene Krümmung berücksichtigt.

In einem Diagrammausschnitt aus Fig. 3a sind in Fig. 3c beispielhaft zwei Messpunkte auf einer Flanke eines Stromrippels dargestellt. Dabei wird die Flankensteigung $m_x$ beispielsweise zwischen den beiden Messpunkten $M_x$ und $M_{x+1}$ ermittelt. Jeder Messpunkt $M_x$, umfasst einen Stromwert $I_{Lx}$ zum Zeitpunkt $t_x$ (x=1,2,..,n). Die Flankensteigung $m_x$ ergibt sich aus der Stromdifferenz $\Delta I_{Lx}$ dividiert durch die den Zeitraum zwischen den beiden Messabtastungen $\Delta t_x$ mit $\Delta I_{Lx}=(I_{L(x+1)}-I_{Lx})$ und $\Delta t_x=(t_{x+1}-t_x)$.

Weiters wird auch ein Wert $U_x$ der Spulenspannung $u_L$ für jeden oder mehrere Messpunkte ermittelt. Wie in Fig. 3b dargestellt ist, kann die als Strich-Punkt-Punkt-Linie 21 dargestellte Spulenspannung $u_L$ über die Dauer einer Flanke zur vereinfachten Darstellung als konstant angenommen werden.

Mit der Flankensteigung $m_x$ und der Spulenspannung $U_x$ kann ein von einem Spulenstrom $I_{Ly}$ abhängiger Wert der Induktivität $L(I_{Ly})$ gemäß der Formel

$$L(I_{L_y}) = \frac{U_x}{m_x}$$

ermittelt werden.

Der so ermittelte Wert der Induktivität bildet mit einem Spulenstrom $I_{Ly}$ ein Wertepaar für ein Induktivitätsprofil. Der Spulenstrom $I_{Ly}$ kann beispielsweise $I_{Ly}=I_{Lx}$ entsprechen, einem Mittelwert $I_{Ly}=(I_{L(x+1)}+I_{Lx})/2$, oder einem aus mehr als zwei Stromwerten $I_{Lx}$ ermittelten Wert. Letzteres macht besonders dann Sinn, wenn eine Steigung aus mehr als zwei Stromwerten ermittelt wird. Zusätzlich kann ein Wertepaar für ein Induktivitätsprofil mit weiteren charakteristischen Werten, wie z.B. einer Temperatur, einer Stromamplitude, dem Vorzeichen der Steigung $m_x$ ergänzt werden, auf Basis welcher eine Einteilung in verschiedene Induktivitätsprofile erfolgen kann. Diese weiteren charakteristischen Werte können sind entweder bereits von den Messpunkten umfasst, oder werden erst bezogen auf ein Wertepaar ermittelt.

Die Flankensteigung $m_x$ und die Spulenspannung $U_x$ kann mithilfe der oben beschriebenen Vorgehensweise für eine Vielzahl von unterschiedlichen Werten $I_{Lx}$ des Spulenstroms $i_L$ ermittelt werden, wobei die ermittelten Werte im Wesentlichen den gesamten Verlauf des Spulenstroms $i_L$ abdecken können, der die Grundwelle 14 des Stroms bildet. Damit lässt sich für ausreichend viele Werte des Spulenstroms $i_L$ jeweils ein Wert $L(I_{Ly})$ für die Induktivität der Filterspule 2 ermitteln, um den gesamten Verlauf des zumindest einen Induktivitätsprofils 6 über den relevanten Strombereich ausreichend genau ermitteln zu können. Dies kann beispielsweise durch ein passendes Regressionsverfahren, beispielsweise eine lineare Regression, erfolgen. In praktischen Versuchen hat sich eine Anpassung an eine Polynomfunktion 2ten Grades für manche Filterspulen 2 als ausreichend gute Näherung erwiesen, je nach Anwendung können jedoch auch Polynomfunktionen höherer Grade oder auch 1-sten Grades (d.h. Darstellung durch eine Gerade) verwendet werden, wenn dies vorteilhaft ist. Mit der Anpassung bzw. Regression kann das Induktivitätsprofil 6 als einfache Formel dargestellt werden, welche die Induktivität der Filterspule 2 in Abhängigkeit vom Spulenstrom darstellt.

Beispielsweise kann ein Induktivitätsprofil als Polynom

$$L(I) = \sum_{i=0}^{n} a_i \cdot I^i$$

mit n>0 dargestellt werden, wobei die Koeffizienten $a_i$ durch die Regressionsanalyse ermittelt werden.

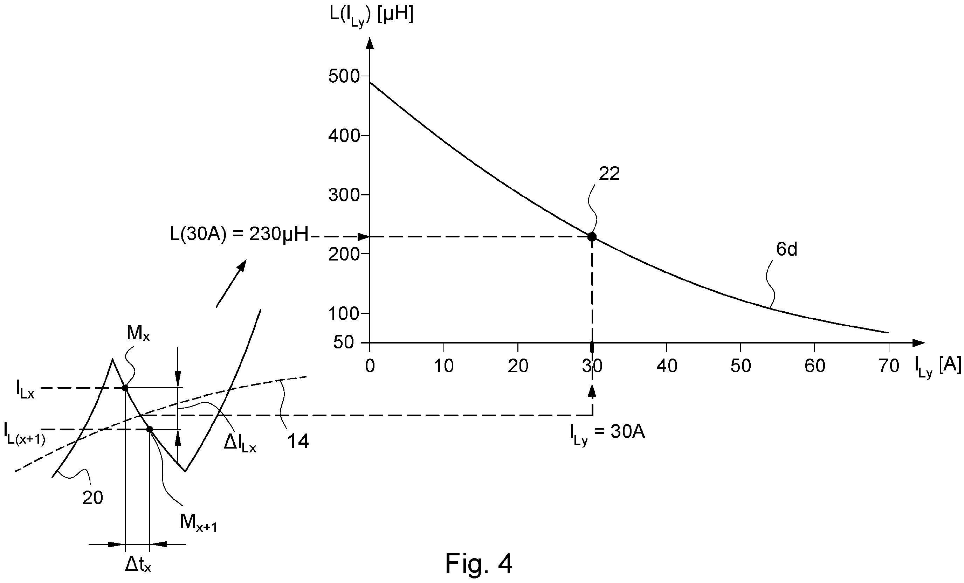

Wenn der qualitative Verlauf des Induktivitätsprofils 6 bekannt ist (bzw. als bekannt angenommen wird), kann das Induktivitätsprofil 6 gegebenenfalls anhand einer einzigen Ermittlung einer Induktivität bei einem bestimmten Spulenstrom ermittelt werden. In Fig. 2 zeigen die Linien 6a, 6b, und 6c mögliche qualitative Verläufe eines Induktivitätsprofils einer Spule, die mit einem ermittelten Induktivitätswert bei einem bestimmten Spulenstrom quantitativ in ihrer Lage angepasst werden können. Fig. 4 zeigt dies anhand eines Induktivitätsprofils 6d, das von 6a aus Fig. 2 mittels zuvor für einen Strom ($I_{Ly}$ = 30A) ermittelten Wert der Induktivität ($L(I_{Ly})$ = 230µH) quantitativ in der Lage angepasst ist. Das Induktivitätsprofil 6d ist mit dem Wertepaar 22 aus $I_{Ly}$ und $L(I_{Ly})$ in seiner Lage bestimmt. Damit lässt sich in Fig. 4 in der Folge von einer Regeleinheit für einen beliebigen Strom $I_{Ly}$ ein Wert der Induktivität ermitteln. Im Beispiel in Fig. 4 wurde für $I_{Ly}$ ein Stromwert zwischen $I_x$ und $I_{x+1}$ definiert und mit 30A angenommen. Dies entspricht im dargestellten Fall in etwa dem Stromwert der Grundwelle 14 während der Messung. Wie bereits zuvor erwähnt, könnte $I_{Ly}$ auch mit $I_{Ly} = I_{Lx}$ oder in sinnvoller Weise beliebig anders definiert werden.

Üblicherweise stehen jedoch ausreichend viele Messungen zur Verfügung, um eine genauere Anpassung auf Basis mehrerer ermittelter Induktivitäten bei unterschiedlichem Spulenstrom durchzuführen.

Für ein bereits ermitteltes Induktivitätsprofil 6 kann in weiterer Folge die Steigung und Krümmung des Induktivitätsprofils 6 ermittelt werden. Wenn das Induktivitätsprofil 6 beispielsweise in Form eines Polynoms vorliegt ist dies mittels erster und zweiter Ableitung nach dem Strom besonders einfach möglich.

Mithilfe des Induktivitätsprofils 6 kann ein Parameter der Regelung laufend an den aktuellen Spulenstrom angepasst werden. Beispielsweise kann ein Proportionalregler mit variablem Verstärkungsfaktor $K_p(L(I))$ definiert werden. Der Wert des Verstärkungsfaktors $K_p$ passt sich dabei ständig an den aktuellen Wert des Stroms an, sodass über den gesamten (sinusförmigen) Stromverlauf immer der gerade passende Wert der Induktivität verwendet wird. Dadurch ist das dynamische Verhalten des Reglers unabhängig von der Stromamplitude des aktuellen Wechselstroms.

In einer erweiterten Ausführung kann mithilfe der Steigung des Induktivitätsprofils 6 ein Parameter der Regelung laufend an den aktuellen Spulenstrom angepasst werden, um die zu erwartende Änderung des Spulenstroms besser abschätzen zu können.

In einer erweiterten Ausführung für Arbeitsbereiche in denen die Induktivitätsprofile besonders ausgeprägt nicht-linear sind, kann zusätzlich mithilfe der Krümmung des Induktivitätsprofils 6 ein Parameter der Regelung laufend an den aktuellen Spulenstrom angepasst werden, um die zu erwartende Änderung des Spulenstroms noch besser abschätzen zu können.

Das obige Verfahren zur Ermittlung des Induktivitätsprofils 6 wird vor der ersten Inbetriebnahme des Wechselrichters 1 durchgeführt. Dies kann für Filterspulen 2 ausreichend sein, deren Induktivitätsprofil über ihre Einsatzdauer nur sehr geringfügigen Änderungen unterworfen sind. Gegebenenfalls kann das Verfahren zusätzlich auch in planmäßigen Intervallen gemäß einem beliebigen Schema vor einer oder vor jeder Inbetriebnahme des Wechselrichters 1 durchgeführt werden. Das Schema kann beispielsweise an Bedingungen geknüpft sein. Beispielsweise kann die Ermittlung immer dann vor einer Inbetriebnahme durchgeführt werden, wenn bei einem letzten Betrieb ein für die Regelqualität charakteristischen Parameterbereich unter- bzw. überschritten wurde. Gegebenenfalls kann die Ermittlung des Induktivitätsprofils 6 zusätzlich auch regelmäßig, unregelmäßig oder ständig während des Betriebs des Wechselrichters 1 durchgeführt werden. Dies ist problemlos möglich, da die Ermittlung des Induktivitätsprofils 6 problemlos während des Echtbetriebs des Wechselrichters 1 durchgeführt werden kann. Beispielsweise kann die Regeleinheit 5 stichprobenartig die Übereinstimmung eines über eine Messung ermittelten Werts der Induktivität mit einem anhand des Induktivitätsprofils 6 ermittelten Wert prüfen. Sollte sich dabei eine zu große Abweichung ergeben, kann die Ermittlung und Aktualisierung des Induktivitätsprofils 6 während des Betriebs durchgeführt oder vor der nächsten Inbetriebnahme eingeplant werden.

Bezugzeichen:

**[0057]**

　Wechselrichter 1
　Filterspule 2
　Phasenleitung 3
　Schaltungseinheit 4
　Regeleinheit 5
　Induktivitätsprofil 6
　Gleichstromquelle 7
　Filtereinheit 8
　Netzrelais 9
　Stromnetze 10
　Filterkondensator 11

Strommesser 13
Grundwelle 14
Messpunkte 15, 16, 17
Geraden 18, 19
Spulenstrom $i_L$ 20
Spulenspannung $u_L$ 21
Wertepaar 22
Spulenstrom $i_L$
Phasenstrom $i_{ac}$
Spulenspannung $u_L$
rechteckige Wechselspannung $u_R$
Filterkondensatorspannung $u_{ac}$
Rechteck-Wechselspannung $u_R$
Flankensteigung m
Induktivität L

**Patentansprüche**

1.  Verfahren zum Betreiben eines Wechselrichters (1), wobei das Verfahren die folgenden Schritte aufweist:

    - mittels einer Schaltungseinheit (4) des Wechselrichters (1) Anlegen einer Wechselspannung an eine Phasenleitung (3), in der eine Filterinduktivität (2) angeordnet ist,
    - Ermitteln von für einen Spulenstrom ($i_L$) und eine Spulenspannung ($u_L$) der Filterinduktivität (2) charakteristischen Werten im Bereich einer Mehrzahl von Messpunkten, wobei zumindest jeweils zwei Messpunkte an zumindest einer Flanke eines Stromrippels liegen,
    - Ermitteln, aus den charakteristischen Werten, eines ersten Werts der Induktivität ($L(I_{Ly})$) der Filterinduktivität (2) für einen ersten Wert des Spulenstroms ($I_{Ly}$),
    - Ermitteln zumindest eines weiteren Wertes der Induktivität der Filterinduktivität (2) für zumindest einen weiteren Wert des Spulenstroms,
    - Ermitteln zumindest eines auf den Spulenstrom bezogenen Induktivitätsprofils (6) der Filterinduktivität (2) unter Verwendung des ermittelten ersten Wertes der Induktivität ($L(I_{Ly})$) der Filterinduktivität und unter Verwendung des zumindest einen weiteren ermittelten Wertes der Induktivität der Filterinduktivität, wobei das Induktivitätsprofil (6) eine Abhängigkeit der Werte der Induktivität ($L(I_{Ly})$) der Filterinduktivität (2) vom Spulenstrom beschreibt,
    - Regeln der Schaltungseinheit (4) des Wechselrichters (1) mittels einer Regeleinheit (5) zur Erzeugung eines Wechselstroms in der Phasenleitung (3), wobei zumindest ein Parameter der Regelung gemäß dem ermittelten stromabhängigen Induktivitätsprofil (6) laufend an den aktuellen Wert der Induktivität angepasst wird, wobei das Induktivitätsprofil (6) vor der ersten Inbetriebnahme des Wechselrichters (1) und gegebenenfalls zusätzlich in planmäßigen Intervallen vor einer oder vor jeder Inbetriebnahme des Wechselrichters (1) ermittelt wird.

2.  Verfahren nach Anspruch 1, **dadurch gekennzeichnet, dass** das Ermitteln des ersten Werts der Filterinduktivität die folgenden Schritte umfasst:

    - Ermitteln einer ersten Flankensteigung ($m_x$) eines Stromrippels für den ersten Wert des Spulenstroms $I_{Ly}$,
    - Ermitteln eines ersten Werts ($U_x$) der Spulenspannung bei der ersten Flankensteigung,
    - Ermitteln des ersten Werts ($L(I_{Ly})$) der Filterinduktivität (2) aus der ersten Flankensteigung ($m_x$) und dem ersten Wert der Spulenspannung ($U_x$) gemäß der Formel

    $$L(I_{L_y}) = \frac{U_x}{m_x}.$$

3.  Verfahren nach Anspruch 1 oder 2, **dadurch gekennzeichnet, dass** die Ermittlung des Spulenstroms durch eine Messung mit einer Abtastfrequenz erfolgt, die zumindest dem zweifachen und vorzugsweise einem Vielfachen einer Taktfrequenz einer über die Schaltungseinheit (4) umgesetzten Pulsweitenmodulation entspricht.

4.  Verfahren nach Anspruch 3, **dadurch gekennzeichnet, dass** die Flankensteigung durch Bilden der Stromdifferenz zwischen zumindest zwei Abtastschritten und unter Berücksichtigung der Abtastfrequenz ermittelt wird.

5.  Verfahren nach Anspruch 1 bis 4, **dadurch gekennzeichnet, dass** nach der Ermittlung des Induktivitätsprofils (6) dessen Steigung und/oder Krümmung ermittelt wird.

6.  Verfahren nach Anspruch 5, **dadurch gekennzeichnet, dass** bei der Regelung der Schaltungseinheit (4) des Wechselrichters (1) mittels einer Regeleinheit (5) zur Erzeugung eines Wechselstroms in einer Phasenleitung (3) zumindest ein Parameter der Regelung laufend an den aktuellen Wert der Steigung und/oder Krümmung des Induktivitätsprofils (6) angepasst wird.

7.  Verfahren nach einem der Ansprüche 1 bis 6, **dadurch gekennzeichnet, dass** zumindest ein weiteres Induktivitätsprofil einer weiteren Filterinduktivität in einer weiteren Phasenleitung ermittelt und bei der Regelung berücksichtigt wird.

8.  Verfahren nach einem der Ansprüche 1 bis 7 **dadurch gekennzeichnet, dass** die Ermittlung des Induktivitätsprofils (6) zusätzlich regelmäßig, unregelmäßig oder ständig während des Betriebs des Wechselrichters (1) durchgeführt wird.

9. Verfahren nach einem der Ansprüche 1 bis 8, **dadurch gekennzeichnet, dass** in einem Stromrippel eine Mehrzahl an Werten der Filterinduktivität ermittelt und daraus ein Mittelwert gebildet wird, wobei das Induktivitätsprofil (6) der Filterinduktivität (2) unter Verwendung des Mittelwertes ermittelt wird.

10. Verfahren nach einem der Ansprüche 1 bis 9, **dadurch gekennzeichnet, dass** ein erstes Induktivitätsprofil aus Flanken mit positiver Steigung und ein zweites Induktivitätsprofil aus Flanken mit negativer Steigung ermittelt wird.

11. Verfahren nach einem der Ansprüche 1 bis 10, **dadurch gekennzeichnet, dass** für eine Mehrzahl von Stromamplituden eines Wechselstroms jeweils zumindest ein Induktivitätsprofil ermittelt wird.

12. Wechselrichter (1) mit einer Schaltungseinheit (4), mit der eine Wechselspannung an zumindest eine Phasenleitung (3) anlegbar ist, wobei in der Phasenleitung (3) eine Filterinduktivität (2) angeordnet ist und wobei die Schaltungseinheit (4) mittels einer Regeleinheit (5) geregelt wird, wobei ein Spulenstrom ($i_L$) der Filterinduktivität (2) und eine Spulenspannung ($u_L$) der Filterinduktivität (2) von der Regeleinheit (5) ermittelbar ist, wobei die Regeleinheit (5) oder eine andere Recheneinheit des Wechselrichters ausgebildet ist, die folgenden Schritte auszuführen:

    - Ansteuern der Schaltungseinheit (4) zum Anlegen einer Wechselspannung an eine Phasenleitung (3) des Wechselrichters (1),
    - Ermitteln eines ersten Werts ($L(l_y)$) der Filterinduktivität (2) für einem ersten Wert des Spulenstroms ($l_y$),
    - Ermitteln zumindest eines weiteren Wertes der Filterinduktivität für einem weiteren Wert des Spulenstroms,
    - Ermitteln eines auf den Spulenstrom bezogenen Induktivitätsprofils (6) der Filterinduktivität (2) unter Verwendung des ermittelten ersten Wertes der Filterinduktivität und unter Verwendung des zumindest einen ermittelten weiteren Wertes der Filterinduktivität, wobei das Induktivitätsprofil (6) eine Abhängigkeit der Werte der Induktivität ($L(l_{L_y})$) der Filterinduktivität (2) vom Spulenstrom beschreibt,
    - Regeln der Schaltungseinheit (4) des Wechselrichters (1) zur Erzeugung eines Wechselstroms in der Phasenleitung (3), wobei zumindest ein Parameter der Regelung gemäß dem ermittelten stromabhängigen Induktivitätsprofil laufend an den aktuellen Spulenstrom angepasst wird,

und wobei die Regeleinheit (5) oder eine andere Recheneinheit des Wechselrichters ausgebildet ist, das Induktivitätsprofil der Filterinduktivität (2) vor der ersten Inbetriebnahme des Wechselrichters (1) und gegebenenfalls zusätzlich in planmäßigen Intervallen vor einer oder vor jeder Inbetriebnahme des Wechselrichters (1) zu ermitteln.

13. Wechselrichter (1) nach Anspruch 12, **dadurch gekennzeichnet, dass** die Regeleinheit (5) oder eine andere Recheneinheit des Wechselrichters ausgebildet ist, die Ermittlung des Induktivitätsprofils (6) der Filterinduktivität (2) zusätzlich regelmäßig, unregelmäßig oder ständig während des Betriebs des Wechselrichters (1) durchzuführen.

14. Wechselrichter (1) nach Anspruch 12 oder 13, **dadurch gekennzeichnet, dass** der Wechselrichter (1) mehrere Phasen (3) mit jeweils einer Filterinduktivität aufweist, wobei für jede Filterinduktivität ein Induktivitätsprofil ermittelbar ist.

15. Wechselrichter nach einem der Ansprüche 12 bis 14, **dadurch gekennzeichnet, dass** die Ermittlung des Induktionsprofils außerhalb der Regeleinheit durch einen dezidierten Mikrokontroller, eine Steuerung, oder einer anderen Recheneinheit durchgeführt wird.

**Claims**

1. A method for operating an inverter (1), the method having the following steps:

    - by means of a switching unit (4) of the inverter (1), applying an AC voltage to a phase line (3) in which a filter inductor (2) is arranged,
    - determining characteristic values of a coil current ($i_L$) and a coil voltage ($u_L$) of the filter inductor (2) in the region of a plurality of measurement points, wherein at least two measurement points are together located on at least one flank of a current ripple,
    - determining, from the characteristic values, a first value of the inductance ($L(l_{L_y})$) of the filter inductor (2) for a first value of the coil current ($l_{L_y}$),
    - determining at least one further value of the inductance of the filter inductor (2) for at least one further value of the coil current,
    - determining at least one inductance profile (6) of the filter inductor (2) with respect to the coil current, using the determined first value of the inductance ($L(l_{L_y})$) of the filter inductor, and using the at least one further determined value of the inductance of the filter inductor (2), wherein the inductance profile (6) describes a dependency of the values of the inductance ($L(I_{L_y})$) of the filter inductor (2) on the coil current,
- controlling the switching unit (4) of the inverter (1), by means of a control unit (5), to generate an alternating current in the phase line (3), wherein at least one parameter of the control is continuously adapted to the momentary value of the inductance according to a determined current-dependent inductance profile (6),

wherein the inductance profile (6) is determined before the inverter (1) is first put into operation, and optionally additionally at scheduled intervals before a, or before each, startup of the inverter (1).

2. The method according to claim 1, **characterized in that** the determination of the first value of the filter inductance comprises the following steps:

- determining a first flank slope ($m_x$) of a current ripple for the first value of the coil current ($I_{Ly}$),
- determining a first value ($U_x$) of the coil voltage at the first flank slope,
- determining the first value ($L(I_{Ly})$) of the inductance of the filter inductor (2) from the first flank slope ($m_x$) and the first value of the coil voltage ($U_x$), according to the formula

$$L(I_{L_y}) = \frac{U_x}{m_x}.$$

3. The method according to claim 1 or 2, **characterized in that** the coil current is determined by measuring with a sampling frequency which corresponds to at least double, and preferably a multiple, of a clock frequency of a pulse width modulation implemented via the switching unit (4).

4. The method according to claim 3, **characterized in that** the flank slope is determined by finding the current difference between at least two sampling steps, and taking into account the sampling frequency.

5. The method according to claims 1 to 4, **characterized in that**, after the inductance profile (6) has been determined, its slope and/or curvature is determined.

6. The method according to claim 5, **characterized in that**, when the switching unit (4) of the inverter (1) is controlled by means of a control unit (5) to generate an alternating current in a phase line (3), at least one parameter of the control is continuously adapted to the momentary value of the slope and/or the curvature of the inductance profile (6).

7. The method according to any of claims 1 to 6, **characterized in that** at least one further inductance profile of a further filter inductor in a further phase line is determined and taken into account in the control process.

8. The method according to any of claims 1 to 7, **characterized in that** the determination of the inductance profile (6) is additionally carried out regularly, irregularly, or constantly during operation of the inverter (1).

9. The method according to any of claims 1 to 8, **characterized in that** a plurality of values of the filter inductance is determined in a current ripple, and a mean value is formed therefrom, the inductance profile (6) of the filter inductor (2) being determined using the mean value.

10. The method according to any of claims 1 to 9, **characterized in that** a first inductance profile is determined from flanks with a positive slope, and a second inductance profile is determined from flanks with a negative slope.

11. The method according to any of claims 1 to 10, **characterized in that** at least one inductance profile is determined for each of a plurality of current amplitudes of an alternating current.

12. An inverter (1) having a switching unit (4) with which an AC voltage can be applied to at least one phase line (3), wherein a filter inductor (2) is arranged in the phase line (3), and wherein the switching unit (4) is controlled by a control unit (5), wherein a coil current ($i_L$) of the filter inductor (2) and a coil voltage ($u_L$) of the filter inductor (2) can be determined by the control unit (5), wherein the control unit (5) or a further computing unit of the inverter is designed to carry out the following steps:

- activating the switching unit (4) to apply an AC voltage to a phase line (3) of the inverter (1),
- determining a first value ($L(I_y)$) of the filter inductor (2) for a first value of the coil current ($I_y$),
- determining at least one further value of the filter inductance for a further value of the coil current,
- determining an inductance profile (6) of the filter inductor (2) with respect to the coil current, using the determined first value of the filter inductance, and using the at least one determined further value of the filter inductance, wherein the inductance profile (6) describes a dependency of the values of the inductance ($L(I_{Ly})$) of the filter inductor (2) on the coil current,

- controlling the switching unit (4) of the inverter (1) to generate an alternating current in the phase line (3), wherein at least one parameter of the control is continuously adapted to the momentary coil current according to the determined current-dependent inductance profile,

and wherein the control unit (5) or another computing unit of the inverter is designed to determine the inductance profile of the filter inductor (2) before the inverter (1) is first put into operation, and optionally additionally at scheduled intervals before a, or before each, start-up of the inverter (1).

13. The inverter (1) according to claim 12, **characterized in that** the control unit (5) or another computing unit of the inverter is designed to determine the inductance profile (6) of the filter inductor (2) additionally regularly, irregularly, or constantly during the operation of the inverter (1).

14. The inverter (1) according to claim 12 or 13, **characterized in that** the inverter (1) has a plurality of phases (3), each with a filter inductor, and an inductance profile can be determined for each filter inductor.

15. The inverter according to any of claims 12 to 14, **characterized in that** the determination of the induction profile is carried out outside the control unit by a dedicated microcontroller, a controller, or another computing unit.

**Revendications**

1. Procédé destiné à faire fonctionner un onduleur (1), le procédé présentant les étapes suivantes :

   - au moyen d'une unité de commutation (4) de l'onduleur (1), application d'une tension alternative à une ligne de phase (3), dans laquelle une inductance de filtre (2) est agencée,
   - détermination de valeurs caractéristiques pour un courant de bobine ($i_L$) et une tension de bobine ($u_L$) de l'inductance de filtre (2) dans la plage d'une pluralité de points de mesure, au moins respectivement deux points de mesure se situant au niveau d'au moins un flanc d'une ondulation de courant,
   - détermination, à partir des valeurs caractéristiques, d'une première valeur de l'inductance ($L(I_{Ly})$) de l'inductance de filtre (2) pour une première valeur du courant de bobine ($I_{Ly}$),
   - détermination d'au moins une autre valeur de l'inductance de l'inductance de filtre (2) pour au moins une autre valeur du courant de bobine,
   - détermination d'au moins un profil d'inductance (6), se rapportant au courant de bobine, de l'inductance de filtre (2) en utilisant la première valeur déterminée de l'inductance ($L(I_{Ly})$) de l'inductance de filtre et en utilisant l'au moins une autre valeur déterminée de l'inductance de l'inductance de filtre, le profil d'inductance (6) décrivant une dépendance des valeurs de l'inductance ($L(I_{Ly})$) de l'inductance de filtre (2) du courant de bobine,
   - régulation de l'unité de commutation (4) de l'onduleur (1) au moyen d'une unité de régulation (5) pour la génération d'un courant alternatif dans la ligne de phase (3), au moins un paramètre de la régulation étant adapté en continu à la valeur réelle de l'inductance selon le profil d'inductance (6) déterminé, dépendant du courant,

le profil d'inductance (6) étant déterminé avant la première mise en service de l'onduleur (1) et le cas échéant en plus à des intervalles planifiés avant une ou avant chaque mise en service de l'onduleur (1).

2. Procédé selon la revendication 1, **caractérisé en ce que** la détermination de la première valeur de l'inductance de filtre comprend les étapes suivantes :

   - détermination d'une première pente de flanc ($m_x$) d'une ondulation de courant pour la première valeur du courant de bobine $I_{Ly}$,
   - détermination d'une première valeur ($U_x$) de la tension de bobine au niveau de la première pente de flanc,
   - détermination d'une première valeur ($L(I_{Ly})$) de l'inductance de filtre (2) à partir de la première pente de flanc ($m_x$) et de la première valeur de la tension de bobine ($U_x$) selon la formule

$$L(I_{L_y}) = \frac{U_x}{m_x}$$

3. Procédé selon la revendication 1 ou 2, **caractérisé en ce que** la détermination du courant de bobine est effectuée par une mesure avec une fréquence de balayage qui correspond au moins au double et de préférence à un multiple d'une fréquence de cycle d'une modulation de largeur de phase transformée par l'intermédiaire de l'unité de commutation (4).

4. Procédé selon la revendication 3, **caractérisé en ce que** la pente de flanc est déterminée par formation de la différence de courant entre au moins deux étapes de balayage et en tenant compte de la fréquence de balayage.

5. Procédé selon la revendication 1 à 4, **caractérisé**

**en ce qu'**après la détermination du profil d'inductance (6), sa pente et/ou sa courbure est/sont déterminée(s).

6. Procédé selon la revendication 5, **caractérisé en ce que** lors de la régulation de l'unité de commutation (4) de l'onduleur (1) au moyen d'une unité de régulation (5) pour générer un courant alternatif dans une ligne de phase (3), au moins un paramètre de la régulation est adapté en continu à la valeur réelle de la pente et/ou de la courbure du profil d'inductance (6).

7. Procédé selon l'une quelconque des revendications 1 à 6,
   **caractérisé en ce qu'**au moins un autre profil d'inductance d'une autre inductance de filtre dans une autre ligne de phase est déterminé et pris en compte lors de la régulation.

8. Procédé selon l'une quelconque des revendications 1 à 7,
   **caractérisé en ce que** la détermination du profil d'inductance (6) est en outre réalisée régulièrement, irrégulièrement ou en continu pendant le fonctionnement de l'onduleur (1).

9. Procédé selon l'une quelconque des revendications 1 à 8,
   **caractérisé en ce qu'**une pluralité de valeurs de l'inductance de filtre est déterminée dans une ondulation de courant et une valeur moyenne est formée à partir de celles-ci, le profil d'inductance (6) de l'inductance de filtre (2) étant déterminé en utilisant la valeur moyenne.

10. Procédé selon l'une quelconque des revendications 1 à 9,
    **caractérisé en ce qu'**un premier profil d'inductance est déterminé à partir de flancs pourvus d'une pente positive et un second profil d'inductance est déterminé à partir de flancs pourvus d'une pente négative.

11. Procédé selon l'une quelconque des revendications 1 à 10,
    **caractérisé en ce qu'**au moins un profil d'inductance est déterminé respectivement pour une pluralité d'amplitudes de courant d'un courant alternatif.

12. Onduleur (1) comportant une unité de commutation (4), qui permet d'appliquer une tension alternative à au moins une ligne de phase (3), une inductance de filtre (2) étant agencée dans la ligne de phase (3) et l'unité de commutation (4) étant régulée au moyen d'une unité de régulation (5), un courant de bobine ($i_L$) de l'inductance de filtre (2) et une tension de bobine ($u_L$) de l'inductance de filtre (2) pouvant être déterminés par l'unité de régulation (5), l'unité de régulation (5) ou une autre unité de calcul de l'onduleur étant conçue pour mettre en oeuvre les étapes suivantes :

    - commande de l'unité de commutation (4) pour l'application d'une tension alternative à une ligne de phase (3) de l'onduleur (1),
    - détermination d'une première valeur ($L(I_y)$) de l'inductance de filtre (2) pour une première valeur du courant de bobine ($I_y$),
    - détermination d'au moins une autre valeur de l'inductance de filtre pour une autre valeur du courant de bobine,
    - détermination d'un profil d'inductance (6), se rapportant au courant de bobine, de l'inductance de filtre (2) en utilisant la première valeur déterminée de l'inductance de filtre et en utilisant l'au moins une autre valeur déterminée de l'inductance de filtre, le profil d'inductance (6) décrivant une dépendance des valeurs de l'inductance ($L(I_{L_y})$) de l'inductance de filtre (2) du courant de bobine,
    - régulation de l'unité de commutation (4) de l'onduleur (1) pour la génération d'un courant alternatif dans la ligne de phase (3), au moins un paramètre de la régulation étant adapté en continu à la valeur réelle du courant de bobine selon le profil d'inductance déterminé, dépendant du courant,

    et l'unité de régulation (5) ou une autre unité de calcul de l'onduleur étant conçue pour déterminer le profil d'inductance de l'inductance de filtre (2) avant la première mise en service de l'onduleur (1) et le cas échéant en plus à des intervalles planifiés avant une ou avant chaque mise en service de l'onduleur (1).

13. Onduleur (1) selon la revendication 12, **caractérisé en ce que** l'unité de régulation (5) ou une autre unité de calcul de l'onduleur est conçue pour réaliser en plus la détermination du profil d'inductance (6) de l'inductance de filtre (2) régulièrement, irrégulièrement ou en continu pendant le fonctionnement de l'onduleur (1).

14. Onduleur (1) selon la revendication 12 ou 13, **caractérisé en ce que** l'onduleur (1) présente plusieurs phases (3) comportant respectivement une inductance de filtre, un profil d'inductance pouvant être déterminé pour chaque inductance de filtre.

15. Onduleur selon l'une quelconque des revendications 12 à 14, **caractérisé en ce que** la détermination du profil d'inductance est réalisée en dehors de l'unité de régulation par un microcontrôleur dédié, une commande ou une autre unité de calcul.

Fig. 1

L[μH]

6b

6a

6c

0   10   20   30   40   50   60   70   i$_L$ [A]

Fig. 2

i$_L$

14

20

t

Fig. 3a

Fig. 3b

Fig. 3c

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20150016162 A1

- EP 3236568 A1

**In der Beschreibung aufgeführte Nicht-Patentliteratur**

- **WU FENGJIANG et al.** *Improved Elimination Scheme of Current Zero-Crossing Distortion in Unipolar Hysteresis Current Controlled Grid-Connected Inverter,* 2015